# EUROPÄISCHE PATENTSCHRIFT

(11) **EP 2 607 525 B1**
(45) Veröffentlichungstag und Bekanntmachung des Hinweises auf die Patenterteilung: **13.08.2014**
(21) Anmeldenummer: 12196076.9
(22) Anmeldetag: 07.12.2012
(51) Int. Cl.: C30B 13/20, C30B 13/30

(54) **Verfahren und Vorrichtung zur Herstellung eines Einkristalls**
Method and apparatus for producing a single crystal
Procédé et dispositif de fabrication d'un monocristal

(30) Priorität: 21.12.2011 DE 102011089429
(43) Veröffentlichungstag der Anmeldung: 26.06.2013
(73) Patentinhaber: Siltronic AG, 81737 München (DE)
(72) Erfinder: Raming, Georg, Dr., 84367 Tann (DE); Altmannshofer, Ludwig, 83661 Lenggries (DE); Ratnieks, Gundars, 84489 Burghausen (DE); Landrichinger, Johann, 5274 Burgkirchen (AT); Lobmeyer, Josef, 94072 Bad Füssing (DE); Holzinger, Alfred, 5144 Handenberg (AT)
(74) Vertreter: Staudacher, Wolfgang

(56) Entgegenhaltungen:
- EP-A1- 0 490 071
- EP-A1- 2 246 461
- DE-A1- 1 794 206
- DE-A1- 3 007 416
- DE-A1-102004 058 547
- DE-B- 1 217 925
- GB-A- 1 249 401
- JP-A- 7 157 388

## Beschreibung

Gegenstand der Erfindung ist ein Verfahren zur Herstellung eines Einkristalls durch Zonenziehen und eine Vorrichtung, die zur Anwendung des Verfahrens geeignet ist.

In industriellem Maßstab wird das Zonenziehen insbesondere zur Herstellung von Einkristallen aus Silizium eingesetzt. Hierzu wird polykristallines Silizium induktiv geschmolzen und auf einem einkristallinen Keimkristall kristallisiert. Das polykristalline Silizium wird üblicherweise in Form eines Vorratsstabs bereitgestellt, der mittels einer Induktionsheizspule von seinem unteren Ende an beginnend nach und nach geschmolzen wird, wobei eine sich bildende Schmelzenzone aus geschmolzenem Silizium dem Wachstum des Einkristalls dient. Dieses Verfahren wird nachfolgend FZ-Verfahren genannt.

Eine Variante des FZ-Verfahrens, die nachfolgend GFZ-Verfahren genannt wird, verwendet an Stelle eines Vorratsstabs polykristallines Granulat aus Silizium ("granular silicon"). Während beim FZ-Verfahren eine Induktionsheizspule zum Schmelzen des Vorratsstabs und zum kontrollierten Kristallisieren des Einkristalls verwendet wird, kommen beim GFZ-Verfahren zwei Induktionsheizspulen zum Einsatz. Das polykristalline Granulat wird mit Hilfe einer ersten Induktionsheizspule auf einem Teller geschmolzen und fließt anschließend durch ein Loch im Zentrum des Tellers zum wachsenden Einkristall und bildet eine Schmelzenzone. Die Kristallisation des Einkristalls wird mit Hilfe einer zweiten Induktionsheizspule kontrolliert, die unter der ersten Induktionsheizspule angeordnet ist. Weitere Einzelheiten zum GFZ-Verfahren sind beispielsweise in der US 2011/0095018 A1 beschrieben.

Die Druckschriften JPH07-157388 A und EP2246461 beschreiben Zonenziehverfahren, bei denen eine Strahlungsheizung eingesetzt wird, deren Strahlung hauptsächlich auf die Schmelzzone reflektiert wird.

Druckschrift EP0490071 A1 offenbart eine Vorrichtung zur Herstellung von fehlerarmen Kristallen im Zonenschmelzverfahren. Die Vorrichtung umfasst Nachheizer und Kühleinrichtungen, wobei zwischen Nachheizer und Schmelzzone ein größerer Abstand besteht, als zwischen Schmelzzone und Kühleinrichtungen.

Druckschrift DE102004058547 A1 beschreibt einen Nachheizer zum Aufheizen eines Keimkristalls und zum Erzeugen eines ausreichend kleinen axialen Temperaturgradienten zwischen Schmelzzone und Aufnahme des Keimkristalls. Im Bereich der Nachheizung soll eine Temperatur knapp unterhalb der Schmelztemperatur des Einkristalls erzielt werden.

Druckschrift GB1249401 A beschreibt einen Nachheizer, der vergleichbar ist mit demjenigen, der in DE102004058547 A1 beschrieben ist.

Die Druckschrift D1794206 offenbart eine Vorrichtung und ein Verfahren zur Herstellung von Einkristallen nach dem FZ-Verfahren, bei dem unterhalb der Induktionsspule ein den Einkristall umgebender Ausgleichskörper aus Graphit angeordnet ist, wobei sich die Oberkante des Ausgleichskörpers in Höhe der Kristallisationsgrenze befindet und über die Induktionsspule mitbeheizt wird. Zusätzlich ist noch eine zweite Induktionsheizung mit variabler Position und Leistung vorhanden, um den Ausgleichskörper zu beheizen. Der Effekt des Ausgleichskörpers wird in D8 mit der Symmetrierung des Temperaturfeldes beschreiben, was zu einer Verringerung der Wärmespannung führt.

In der DE 30 07 377 A1 sind das FZ-Verfahren und eine zu dessen Durchführung geeignete Vorrichtung beschrieben, wobei sich die Beschreibung der Aufgabe widmet, das Auftreten von Wärmespannungen zu verhindern. Zur Lösung der Aufgabe wird vorgeschlagen, den Einkristall durch Wärmestrahlung eines den Einkristall umgebenden reflektierenden Schutzmantels nachzuheizen. In der Publikation von A.Muiznieks et al. (Journal of Crystal Growth 230(2001), 305-313) wird die Wirksamkeit eines dort als Reflektor bezeichneten Schutzmantels zum Abbau von Wärmespannungen bestätigt. Simulationsrechnungen zeigen auch, dass die Wärmespannungen im Zentrum der Kristallisationsgrenze am größten sind und dass ihr Beitrag mit dem Durchmesser des Einkristalls ansteigt. Darüber hinaus wird gezeigt, dass Wärmespannungen insbesondere im Zentrum der Kristallisationsgrenze umso größer sind, je stärker die Kristallisationsgrenze zum Einkristall hin durchgebogen ist, und dass die Durchbiegung mit der Kristallisations-Geschwindigkeit des Einkristalls ansteigt.

Es besteht daher eine Notwendigkeit an Maßnahmen, die gegen die Durchbiegung der Kristallisationsgrenze gerichtet sind, ohne die Kristallisations-Geschwindigkeit einschränken zu müssen, und die geeignet sind, Wärmespannungen und die davon ausgehende Gefahr der Bildung von Versetzungen ohne Produktivitätseinbuße einzudämmen.

Da ein den Einkristall umgebender Reflektor den Wärmetransport über den Mantel des Einkristalls behindert, muss der Schmelzenzone weniger Wärme über die Induktionsheizspule zugeführt werden, um eine Höhe der Schmelzenzone zu gewährleisten, die für das Kristallwachstum benötigt wird. Dies ist ein weiterer Vorteil, der mit dem Einsatz eines Reflektors verknüpft ist.

Mit steigendem Durchmesser des Einkristalls und steigender Kristallisations-Geschwindigkeit nimmt die Durchbiegung der Kristallisationsgrenze zu. Damit verschärfen sich die Probleme aufgrund von Wärmespannungen. Als Gegenmaßnahme reicht der Einsatz eines Reflektors dann nicht mehr aus.

Aufgabe der vorliegenden Erfindung ist es daher, der Durchbiegung der Kristallisationsgrenze und der Belastung des Einkristalls durch Wärmespannungen auf vorteilhaftere Weise entgegenzuwirken.

Die Aufgabe wird gelöst durch ein Verfahren zur Herstellung eines Einkristalls durch Zonenziehen, wobei der Einkristall mit Unterstützung einer Induktionsheizspule unter einer Schmelzenzone an einer Kristallisationsgrenze kristallisiert, und das Abstrahlen von Kristallisationswärme durch einen den Einkristall umgebenden Reflektor behindert wird, **dadurch** gekennzeichnet, **dass** der Einkristall im Bereich eines äußeren Rands der Kristallisationsgrenze mittels einer Heizeinrichtung in einer ersten Zone erhitzt wird, wobei ein Abstand Δ zwischen einem äußeren Tripelpunkt Tₐ am äußeren Rand der Kristallisationsgrenze und einem Zentrum Z der Kristallisationsgrenze derart beeinflusst wird, dass der mittels der Heizeinrichtung erhitzte Bereich des Einkristalls in Längsrichtung des Einkristalls vom äußeren Tripelpunkt Tₐ aus eine Länge L hat, die nicht länger als der Abstand Δ ist.

Die Aufgabe wird gleichermaßen gelöst durch eine Vorrichtung gemäß Patentanspruch 12.

Die vorliegende Erfindung verfolgt das Ziel, die Temperatur im Bereich des oberen Endes des Einkristalls von der Seite so zu erhöhen, dass die axiale Lage der Kristallisationsgrenze am Umfang des Einkristalls beeinflusst wird, und zwar derart, dass die Durchbiegung der Kristallisationsgrenze, also der vertikale Abstand zwischen dem Zentrum und dem Rand der Kristallisationsgrenze begrenzt wird.

Die vorliegende Erfindung kann unabhängig davon angewendet werden, ob Silizium oder ein anderes Halbleitermaterial kristallisiert wird und unabhängig davon, ob die Kristallisation nach dem FZ- oder dem GFZ-Verfahren geschieht.

Gemäß einer bevorzugten Ausführungsform der Erfindung wird der Einkristall mittels einer Strahlungsheizung erhitzt, die um das obere Ende des wachsenden Einkristalls angeordnet ist. Die Strahlungsheizung kann beispielsweise IR- oder optische Strahlung emittieren. Besonders bevorzugt ist die Verwendung einer Halogen-Strahlungsheizung.

Als Alternative kann an Stelle einer Strahlungsheizung auch eine Induktionsheizung oder eine Widerstandsheizung oder eine andere Heizeinrichtung verwendet werden, durch die Wärme in den Bereich des äußeren Rands der Kristallisationsgrenze übertragen werden kann.

Die Erfindung wird nachfolgend anhand von Figuren eingehender beschrieben.

Fig.1 ist eine Schnittzeichnung, die den Stand der Technik repräsentiert und eine Hälfte eines Längsschnitts durch einen Einkristall zeigt, der gemäß dem Zonenziehen hergestellt wurde. Neben dem Einkristall sind eine Induktionsheizspule zur Kontrolle der Kristallisation des Einkristalls dargestellt sowie ein den Einkristall umgebender Reflektor, der vom Einkristall abgestrahlte Wärmestrahlung reflektiert.

Fig.2 ist eine die Erfindung repräsentierende Schnittzeichnung.

Fig.3 ist eine weitere, die Erfindung repräsentierende Schnittzeichnung, in der ein zusätzliches bevorzugtes Merkmal gezeigt ist.

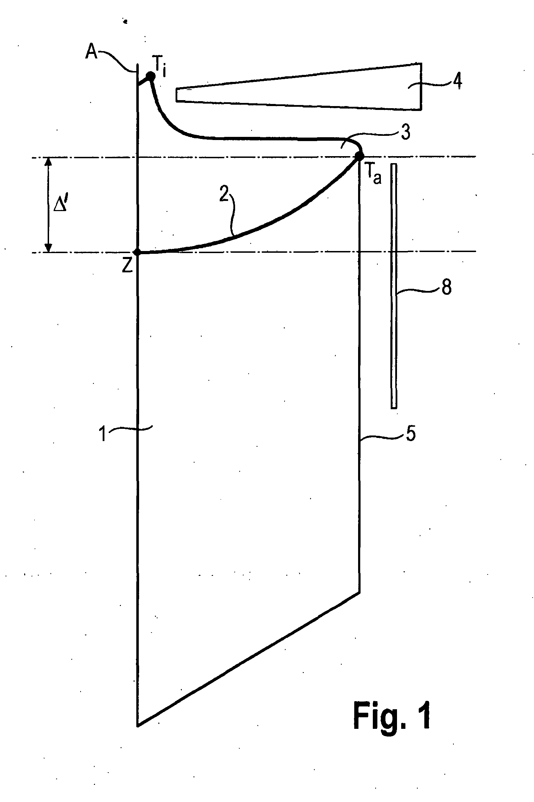

Der Einkristall 1 wächst an einer Kristallisationsgrenze 2 zwischen dem Einkristall und einer Schmelzenzone 3 aus geschmolzenem Material und wird dabei abgesenkt (Fig.1). Das geschmolzene Material stammt vorzugsweise von einem Vorratsstab aus polykristallinem Silizium oder von Granulat aus polykristallinem Silizium. Die Schmelzenzone 3 wird mit Hilfe einer Hochfrequenz-Induktionsheizspule (HF-Induktor) 4 erhitzt. Beim Wachsen des Einkristalls entstehende Kristallisationswärme wird durch den Einkristall geleitet und insbesondere über den Mantel 5 des Einkristalls abgestrahlt. Der Wärmetransport hat zur Folge, dass insbesondere im Bereich der Kristallisationsgrenze 2 ein inhomogenes Temperaturfeld entsteht, das für die Durchbiegung der Kristallisationsgrenze 2 zum Einkristall verantwortlich ist. Die Durchbiegung der Kristallisationsgrenze ist definiert als der axiale Abstand Δ zwischen einem äußeren Tripelpunkt Tₐ am äußeren Rand der Kristallisationsgrenze und dem Zentrum Z der Kristallisationsgrenze 2.

Mit Hilfe eines den Einkristall umgebenden Reflektors 8, der vom Einkristall 1 abgestrahlte Wärmestrahlung reflektiert, wird insbesondere die Lage des Zentrums Z der Kristallisationsgrenze 2 auf der geometrischen Achse A beeinflusst.

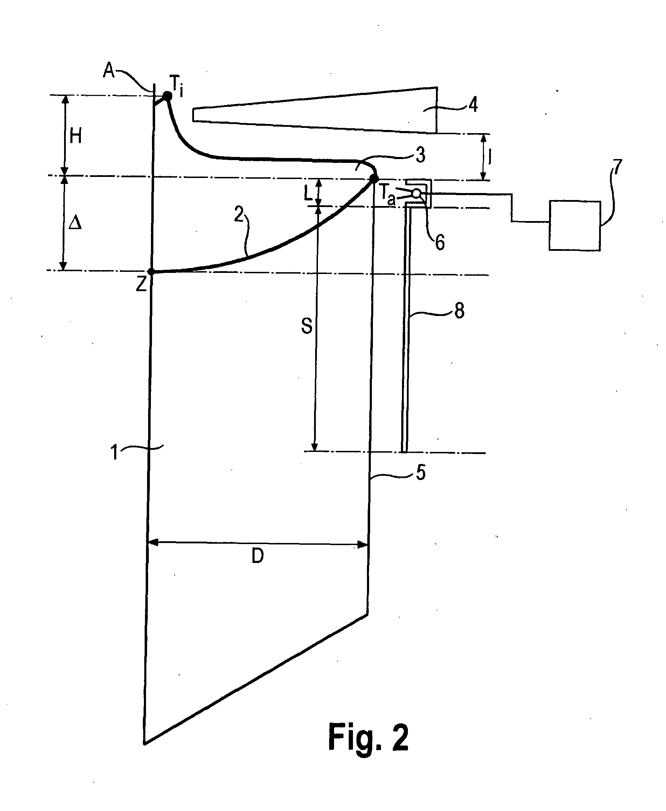

Die vorliegende Erfindung sieht darüber hinaus vor, den Einkristall im Bereich eines äußeren Rands der Kristallisationsgrenze mittels einer Heizeinrichtung 6 zu erhitzen, und auf diese Weise den Abstand Δ zwischen dem äußeren Tripelpunkt Tₐ am äußeren Rand der Kristallisationsgrenze und Zentrum Z der Kristallisationsgrenze 2 zu beeinflussen (Fig.2).

Die Heizeinrichtung 6 ist in unmittelbarer Nachbarschaft des Einkristalls angeordnet, und der Einkristall wird durch die Heizeinrichtung 6 direkt erhitzt.

Mit Hilfe der Heizeinrichtung 6 wird dem Einkristall Energie mit einer elektrischen Leistung von vorzugsweise nicht weniger als 2 kW und nicht mehr als 12 kW, besonders bevorzugt von nicht weniger als 4 kW und nicht mehr als 10kW zugeführt. Die obere Grenze dieses Bereichs ist auf einen Einkristall mit einem Durchmesser von 150 mm bezogen. Soll ein Einkristall mit einem größeren Durchmesser hergestellt werden, ist die obere Grenze dieses Bereichs um einen Faktor entsprechend dem Verhältnis der Durchmesser höher.

Der Einkristall wird mit Hilfe der Heizeinrichtung vorzugsweise derart erhitzt, dass der Abstand Δ zwischen dem äußeren Tripelpunkt Tₐ am äußeren Rand der Kristallisationsgrenze und dem Zentrum Z der Kristallisationsgrenze 2 nicht mehr als 90 % vom Abstand Δ' ist und besonders bevorzugt nicht mehr als 80 %. Der Abstand Δ' ist der Abstand zwischen dem äußeren Tripelpunkt Tₐ und dem Zentrum Z, der besteht, falls auf die Heizeinrichtung 6 verzichtet wird.

Es ist bevorzugt, die elektrische Leistung der Heizeinrichtung 6 in Abhängigkeit der Länge des Einkristalls zu steuern. Zu diesem Zweck ist eine Steuerung 7 vorgesehen, die auf die elektrische Leistung der Heizeinrichtung Einfluss nimmt, beispielsweise eine Steuerung, die die elektrische Leistung der Heizeinrichtung mit zunehmender Länge des Einkristalls herabsetzt.

Es ist darüber hinaus bevorzugt, die elektrische Leistung der Induktionsheizspule und gegebenenfalls zusätzlich die Geschwindigkeit des Absenkens des Einkristalls während des Verfahrens derart zu regeln, dass sich ein gewählter Betrag des Abstands H in der Schmelzenzone nicht verändert, beispielsweise indem der Abstand 1 zwischen dem äußeren Rand der Kristallisationsgrenze und der Hochfrequenz-Induktionsheizspule möglichst konstant gehalten wird. Der Abstand H in der Schmelzenzone entspricht dem Abstand zwischen einem inneren Tripelpunkt Tᵢ am oberen Ende der Schmelzenzone und dem äußeren Tripelpunkt Tₐ am äußeren Rand der Kristallisationsgrenze.

Der mit Hilfe der Heizeinrichtung 6 erhitzte Bereich des Einkristalls entspricht einer ersten Zone, die in Längsrichtung des Einkristalls eine Länge L hat. Die Länge L, die vom äußeren Tripelpunkt Tₐ ausgehend parallel zur geometrischen Achse A (Längsachse) des Einkristalls verläuft, sollte nicht länger als der Abstand Δ und vorzugsweise nicht länger als Δ/2 sein. Der Abstand Δ ist der Abstand zwischen dem äußeren Tripelpunkt Tₐ am äußeren Rand der Kristallisationsgrenze und dem Zentrum Z der Kristallisationsgrenze, der sich bei Benutzung der Erfindung ergibt. Würde die Heizeinrichtung 6 auch einen Bereich unter dem genannten Bereich erhitzen, könnten damit zwar Wärmespannungen verringert werden, die Durchbiegung würde sich jedoch erhöhen. Außerdem stünde eine übermäßige Behinderung des Abflusses von Wärme vom Einkristall durch die Heizeinrichtung 6 einer wirtschaftlichen Kristallisations-Geschwindigkeit entgegen. Aus demselben Grund ist es bevorzugt, die axiale Länge des Reflektors 8 zu begrenzen. Der Reflektor sollte so dimensioniert sein, dass er das Abstrahlen von Kristallisationswärme in einer zweiten Zone behindert, so dass in seinem Einflussbereich die radiale Temperaturverteilung im Einkristall vergleichmäßigt wird. Die zweite Zone schließt sich an die erste Zone an. Sie hat eine Länge S in Längsrichtung des Einkristalls, wobei die Summe der Längen S und L vorzugsweise dem 0,5 bis 1,5-Fachen der Länge des Durchmessers D des Einkristalls entspricht. Der Reflexionsgrad der zum Einkristall gerichteten Innenwand des Reflektors beträgt vorzugsweise nicht weniger als 80 %. Der Reflektor 8 besteht vorzugsweise vollständig aus Silber oder hat zumindest eine Innenwand, die aus Silber besteht. Die Innenwand ist vorzugsweise poliert.

Die Heizeinrichtung 6 ist vorzugsweise unmittelbar über dem Reflektor 8 angeordnet. Sie kann aber auch in das obere Ende des Reflektors 8 integriert sein. Ist das nicht der Fall, können die Heizeinrichtung 6 und der Reflektor 8 mechanisch verbunden oder voneinander getrennt angeordnet sein. Durch das Letztere kann die Wärmeleitung zum Reflektor wirksam eingeschränkt werden. Die Heizeinrichtung 6 ist aus hochtemperaturbeständigem Material mit hohem Reflexionsgrad gefertigt und vorzugsweise als Strahlungsheizung ausgeführt. Besonders bevorzugt ist eine Strahlungsheizung, die eine oder mehrere Halogenlampen umfasst, insbesondere eine Strahlungsheizung, die von einem Ring aus Halogenlampen gebildet wird, der den Einkristall im Bereich des äußeren Rands der Kristallisationsgrenze umgibt.

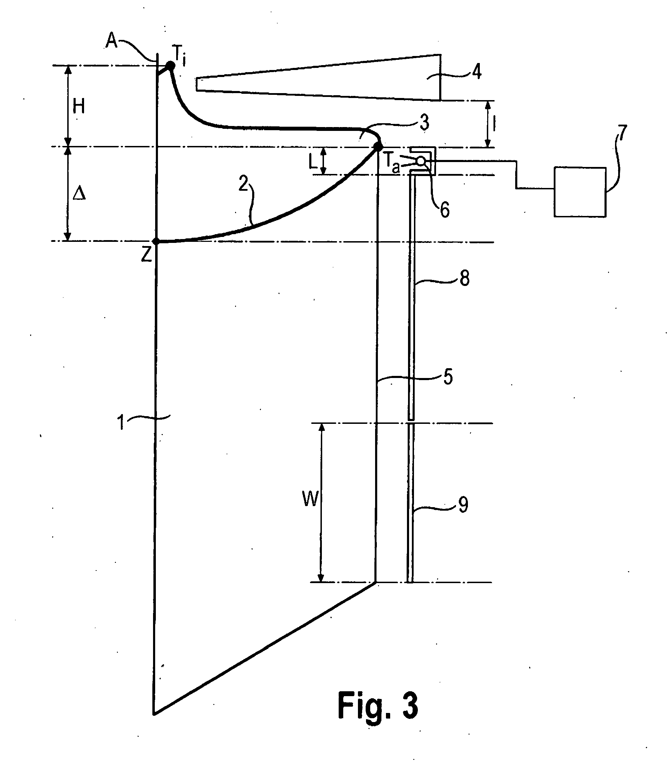

Die in Fig.3 gezeigte erfindungsgemäße Vorrichtung unterscheidet sich von der in Fig.2 gezeigten Vorrichtung im Wesentlichen durch ein zusätzliches Merkmal, nämlich einen den Einkristall umgebenden und Wärmestrahlung aufnehmenden Körper 9. Dieser Körper kann ein passiver Kühlkörper oder eine aktive Kühleinrichtung sein. Er erleichtert das Abstrahlen von Kristallisationswärme durch den Einkristall in einer dritten Zone, die der zweiten Zone folgt. Die dritte Zone hat die Länge W und beginnt in einem Abstand vom äußeren Tripelpunkt Tₐ, der mindestens die Länge des Durchmessers D des Einkristalls hat. Die Länge W der dritten Zone ist vorzugsweise nicht kürzer als die Hälfte des Durchmessers des Einkristalls. Der Körper 9 hat einen Reflexionsgrad von vorzugsweise nicht mehr als 20%. Er ist über eine wärmeisolierende Brücke mit dem Reflektor 8 verbunden oder ohne den Reflektor zu berühren montiert.

## Patentansprüche

1. Verfahren zur Herstellung eines Einkristalls durch Zonenziehen, wobei der Einkristall mit Unterstützung einer Induktionsheizspule unter einer Schmelzenzone an einer Kristallisationsgrenze kristallisiert, und das Abstrahlen von Kristallisationswärme durch einen den Einkristall umgebenden Reflektor behindert wird, **dadurch gekennzeichnet, dass** der Einkristall im Bereich eines äußeren Rands der Kristallisationsgrenze mittels einer Heizeinrichtung in einer ersten Zone erhitzt wird, wobei ein Abstand Δ zwischen einem äußeren Tripelpunkt Tₐ am äußeren Rand der Kristallisationsgrenze und einem Zentrum Z der Kristallisationsgrenze derart beeinflusst wird, dass der mittels der Heizeinrichtung erhitzte Bereich des Einkristalls in Längsrichtung des Einkristalls vom äußeren Tripelpunkt Tₐ aus eine Länge L hat, die nicht länger als der Abstand Δ ist.

2. Verfahren nach Anspruch 1, **dadurch gekennzeichnet, dass** der Einkristall mit Hilfe der Heizeinrichtung derart erhitzt wird, dass der Abstand Δ zwischen dem äußeren Tripelpunkt Tₐ am äußeren Rand der Kristallisationsgrenze und dem Zentrum Z der Kristallisationsgrenze nicht mehr als 90 % von einem Abstand Δ' ist, der zwischen dem äußeren Tripelpunkt Tₐ und dem Zentrum Z besteht, falls auf die Heizeinrichtung verzichtet wird.

3. Verfahren nach Anspruch 1 oder Anspruch 2, **dadurch gekennzeichnet, dass** die elektrische Leistung der Induktionsheizspule derart geregelt wird, dass sich ein gewählter Betrag eines Abstands H in der Schmelzenzone zwischen einem inneren Tripelpunkt Tᵢ an einem oberen Ende der Schmelzenzone und dem äußeren Tripelpunkt Tₐ am äußeren Rand der Kristallisationsgrenze nicht verändert.

4. Verfahren nach einem der Ansprüche 1 bis 3, **dadurch gekennzeichnet, dass** der Einkristall mittels einer Strahlungsheizung als Heizeinrichtung erhitzt wird.

5. Verfahren nach einem der Ansprüche 1 bis 3, **dadurch gekennzeichnet, dass** der Einkristall mittels einer Induktionsheizung als Heizeinrichtung erhitzt wird.

6. Verfahren nach einem der Ansprüche 1 bis 5, **dadurch gekennzeichnet, dass** die elektrische Leistung der Heizeinrichtung in Abhängigkeit der Länge des Einkristalls gesteuert wird.

7. Verfahren nach einem der Ansprüche 1 bis 6, **dadurch gekennzeichnet, dass** mit Hilfe der Heizeinrichtung dem Einkristall Energie mit einer elektrischen Leistung von nicht weniger als 2 kW zugeführt wird.

8. Verfahren nach einem der Ansprüche 1 bis 7, **dadurch gekennzeichnet, dass** durch den Reflektor das Abstrahlen von Kristallisationswärme in einer zweiten Zone behindert wird, die sich an die erste Zone anschließt und die eine Länge S in Längsrichtung des Einkristalls hat, wobei die Summe der Längen S und L dem 0,5- bis 1,5-Fachen des Durchmessers D des Einkristalls entspricht.

9. Verfahren nach Anspruch 8, **dadurch gekennzeichnet, dass** durch einen den Einkristall umgebenden und Wärmestrahlung aufnehmenden Körper das Abstrahlen von Kristallisationswärme in einer dritten Zone erleichtert wird, die der zweiten Zone folgt und die in einem Abstand vom äußeren Tripelpunkt Tₐ beginnt, der mindestens die Länge des Durchmessers des Einkristalls hat.

10. Verfahren nach einem der Ansprüche 1 bis 9, **dadurch gekennzeichnet, dass** die Schmelzenzone durch fortgesetztes Schmelzen eines polykristallinen Vorratsstabs aus Silizium gebildet wird.

11. Verfahren nach einem der Ansprüche 1 bis 9, **dadurch gekennzeichnet, dass** die Schmelzenzone durch fortgesetztes Schmelzen von polykristallinem Granulat aus Silizium gebildet wird.

12. Vorrichtung zur Herstellung eines Einkristalls durch Zonenziehen, umfassend einen den Einkristall umgebenden Reflektor und eine Heizeinrichtung zum Erhitzen des Einkristalls im Bereich eines äußeren Rands einer Kristallisationsgrenze des Einkristalls, wobei die Heizeinrichtung derart dimensioniert ist, dass der mittels der Heizeinrichtung erhitzte Bereich des Einkristalls in Längsrichtung des Einkristalls eine erste Zone ist, die von einem äußeren Tripelpunkt Ta aus eine Länge L hat, die nicht länger als ein Abstand Δ ist, der zwischen dem äußeren Tripelpunkt Tₐ am äußeren Rand der Kristallisationsgrenze und einem Zentrum Z der Kristallisationsgrenze besteht.

13. Vorrichtung nach Anspruch 12, **dadurch gekennzeichnet, dass** die Heizvorrichtung eine Strahlungsheizung ist.

14. Vorrichtung nach Anspruch 12, **dadurch gekennzeichnet, dass** die Heizvorrichtung eine Induktionsheizung ist.

15. Vorrichtung nach einem der Ansprüche 12 bis 14, **dadurch gekennzeichnet, dass** die Heizeinrichtung im Reflektor integriert ist.

16. Vorrichtung nach einem der Ansprüche 12 bis 15, **dadurch gekennzeichnet, dass** der Reflektor das Abstrahlen von Kristallisationswärme durch den Einkristall in einer zweiten Zone behindert, die sich an die erste Zone anschließt und die eine Länge S in Längsrichtung des Einkristalls hat, wobei die Summe der Längen S und L dem 0,5- bis 1,5-Fachen des Durchmessers D des Einkristalls entspricht.

17. Vorrichtung nach Anspruch 16, **gekennzeichnet durch** einen den Einkristall umgebenden und Wärmestrahlung aufnehmenden Körper, der das Abstrahlen von Kristallisationswärme **durch** den Einkristall in einer dritten Zone erleichtert, die der zweiten Zone folgt und die in einem Abstand vom äußeren Tripelpunkt Tₐ beginnt, der mindestens die Länge des Durchmessers D des Einkristalls hat.

## Claims

1. Method for producing a single crystal by means of the floating zone method, wherein the single crystal crystallizes with the support of an induction heating coil below a melt zone at a crystallization boundary, and the emission of crystallization heat is impeded by a reflector surrounding the single crystal, **characterized in that** the single crystal is heated in the region of an outer edge of the crystallization boundary by means of a heating device in a first zone, wherein a distance Δ between an outer triple point Tₐ at the outer edge of the crystallization boundary and a centre Z of the crystallization boundary is influenced in such a way that that region of the single crystal which is heated by means of the heating device has, in the longitudinal direction of the single crystal from the outer triple point Tₐ a length L that is not longer than the distance Δ.

2. Method according to Claim 1, **characterized in that** the single crystal is heated with the aid of the heating device in such a way that the distance Δ between the outer triple point Tₐ at the outer edge of the crystallization boundary and the centre Z of the crystallization boundary is not more than 90% of a distance Δ' that exists between the outer triple point Tₐ and the centre Z if the heating device is dispensed with.

3. Method according to Claim 1 or Claim 2, **characterized in that** the electrical power of the induction heating coil is regulated in such a way that a chosen absolute value of a distance H in the melt zone between an inner triple point Tᵢ at an upper end of the melt zone and the outer triple point Tₐ at the outer edge of the crystallization boundary does not change.

4. Method according to any of Claims 1 to 3, **characterized in that** the single crystal is heated by means of a radiant heating system as heating device.

5. Method according to any of Claims 1 to 3, **characterized in that** the single crystal is heated by means of an induction heating system as heating device.

6. Method according to any of Claims 1 to 5, **characterized in that** the electrical power of the heating device is controlled in a manner dependent on the length of the single crystal.

7. Method according to any of Claims 1 to 6, **characterized in that** energy having an electrical power of not less than 2 kW is fed to the single crystal with the aid of the heating device.

8. Method according to any of Claims 1 to 7, **characterized in that** the reflector impedes the emission of crystallization heat in a second zone, which is adjacent to the first zone and which has a length S in the longitudinal direction of the single crystal, wherein the sum of the lengths S and L corresponds to 0.5 to 1.5 times the diameter D of the single crystal.

9. Method according to Claim 8, **characterized in that** a body surrounding the single crystal and absorbing thermal radiation facilitates the emission of crystallization heat in a third zone, which follows the second zone and which begins at a distance from the outer triple point Tₐ which has at least the length of the diameter of the single crystal.

10. Method according to any of Claims 1 to 9, **characterized in that** the melt zone is formed by continued melting of a polycrystalline feed rod composed of silicon.

11. Method according to any of Claims 1 to 9, **characterized in that** the melt zone is formed by continued melting of polycrystalline granular silicon.

12. Apparatus for producing a single crystal by means of the floating zone method, comprising a reflector surrounding the single crystal, and a heating device for heating the single crystal in the region of an outer edge of a crystallization boundary of the single crystal, wherein the heating device is dimensioned in such a way that that region of the single crystal which is heated by means of the heating device is, in the longitudinal direction of the single crystal, a first zone, which, from an outer triple point Tₐ, has a length L that is not longer than a distance Δ that exists between the outer triple point Tₐ at the outer edge of the crystallization boundary and a centre Z of the crystallization boundary.

13. Apparatus according to Claim 12, **characterized in that** the heating device is a radiant heating system.

14. Apparatus according to Claim 12, **characterized in that** the heating device is an induction heating system.

15. Apparatus according to any of Claims 12 to 14, **characterized in that** the heating device is integrated in the reflector.

16. Apparatus according to any of Claims 12 to 15, **characterized in that** the reflector impedes the emission of crystallization heat by the single crystal in a second zone, which is adjacent to the first zone and which has a length S in the longitudinal direction of the single crystal, wherein the sum of the lengths S and L corresponds to 0.5 to 1.5 times the diameter D of the single crystal.

17. Apparatus according to Claim 16, **characterized by** a body surrounding the single crystal and absorbing thermal radiation, said body facilitating the emission of crystallization heat by the single crystal in a third zone, which follows the second zone and which begins at a distance from the outer triple point Tₐ that has at least the length of the diameter D of the single crystal.

## Revendications

1. Procédé de fabrication d'un monocristal par étirement localisé, le monocristal cristallisant à une frontière de cristallisation en dessous d'une zone de fusion avec le soutien d'une bobine de chauffage par induction, le rayonnement de la chaleur de cristallisation étant empêché par un réflecteur qui entoure le monocristal,
**caractérisé en ce que**
le monocristal est chauffé dans une première zone située au niveau du bord extérieur de la frontière de cristallisation au moyen d'un dispositif de chauffage, la distance Δ entre un point triple externe Tₐ situé au bord extérieur de la frontière de cristallisation et le centre Z de la frontière de cristallisation étant influencée de telle sorte que la zone du monocristal chauffé au moyen du dispositif de chauffage présente dans le sens de la longueur du monocristal et à partir du point triple externe Tₐ une longueur L qui n'est pas supérieure à la distance Δ.

2. Procédé selon la revendication 1, **caractérisé en ce que** le monocristal est chauffé à l'aide du dispositif de chauffage de telle sorte que la distance Δ entre le point triple externe Tₐ situé sur le bord extérieur de la frontière de cristallisation et le centre Z de la frontière de cristallisation ne représente pas plus de 90 % de la distance Δ' qui sépare le point triple externe Tₐ et le centre Z lorsque le dispositif de chauffage est absent.

3. Procédé selon la revendication 1 ou la revendication 2, **caractérisé en ce que** la puissance électrique de la bobine de chauffage par induction est régulée de telle sorte qu'une fraction sélectionnée de la distance H qui s'étend dans la zone de fusion entre un point triple externe Tᵢ situé à l'extrémité supérieure de la zone de fusion et le point triple externe Tₐ situé sur le bord externe de la frontière de cristallisation ne se modifie pas.

4. Procédé selon l'une des revendications 1 à 3, **caractérisé en ce que** le monocristal est chauffé au moyen d'un chauffage radiant servant de dispositif de chauffage.

5. Procédé selon l'une des revendications 1 à 3, **caractérisé en ce que** le monocristal est chauffé au moyen d'un chauffage par induction utilisé comme dispositif de chauffage.

6. Procédé selon l'une des revendications 1 à 5, **caractérisé en ce que** la puissance électrique du dispositif de chauffage est commandée en fonction de la longueur du monocristal.

7. Procédé selon l'une des revendications 1 à 6, **caractérisé en ce que** de l'énergie est apportée au monocristal au moyen du dispositif de chauffage à une puissance électrique non inférieure à 2 kW.

8. Procédé selon l'une des revendications 1 à 7, **caractérisé en ce que** le rayonnement de la chaleur de cristallisation est empêché par le réflecteur dans une deuxième zone qui est adjacente à la première zone et qui présente une longueur S dans le sens de la longueur du monocristal, la somme des longueurs S et L correspondant à 0,5 à 1,5 fois le diamètre D du monocristal.

9. Procédé selon la revendication 8, **caractérisé en ce que** le rayonnement de la chaleur de cristallisation est facilité dans une troisième zone par un corps qui entoure le monocristal et qui reprend le rayonnement thermique, la troisième zone suivant la deuxième zone et commençant à une distance du point triple externe Tₐ qui correspond au moins à la longueur du diamètre du monocristal.

10. Procédé selon l'une des revendications 1 à 9, **caractérisé en ce que** la zone de fusion est formée par la progression de la fusion d'un barreau polycristallin de réserve de silicium.

11. Procédé selon l'une des revendications 1 à 9, **caractérisé en ce que** la zone de fusion est formée par la progression de la fusion de granulés polycristallins de silicium.

12. Dispositif de fabrication d'un monocristal par étirage localisé, comprenant un réflecteur qui entoure le monocristal et un dispositif de chauffage qui chauffe le monocristal au niveau du bord extérieur d'une frontière de cristallisation du monocristal, le dispositif de chauffage étant dimensionné de telle sorte que la partie du monocristal chauffée par le dispositif de chauffage est une première zone qui s'étend dans le sens de la longueur du monocristal et qui possède une longueur L partant d'un point triple extérieur Tₐ et dont la longueur n'est pas plus longue que la distance Δ qui s'établit entre le point triple externe Tₐ situé sur le bord extérieur de la frontière de cristallisation et le centre Z de la frontière de cristallisation.

13. Dispositif selon la revendication 12, **caractérisé en ce que** le dispositif de chauffage est un chauffage radiant.

14. Dispositif selon la revendication 12, **caractérisé en ce que** le dispositif de chauffage est un chauffage par induction.

15. Dispositif selon l'une des revendications 12 à 14, **caractérisé en ce que** le dispositif de chauffage est intégré dans le réflecteur.

16. Dispositif selon l'une des revendications 12 à 15, **caractérisé en ce que** le réflecteur empêche le rayonnement de la chaleur de cristallisation par le monocristal dans une deuxième zone adjacente à la première zone et qui présente dans le sens de la longueur du monocristal une longueur S, la somme des longueurs S et L correspondant à 0,5-1,5 fois le diamètre D du monocristal.

17. Dispositif selon la revendication 16, **caractérisé par** un corps qui entoure le monocristal et qui reprend le rayonnement thermique, qui facilite le rayonnement de la chaleur de cristallisation par le monocristal dans une troisième zone qui suit la deuxième zone et qui commence à une distance du point triple extérieur Tₐ qui a au moins la longueur du diamètre D du monocristal.
